# EUROPÄISCHE PATENTSCHRIFT

(11) **EP 1 593 978 B1**
(45) Veröffentlichungstag und Bekanntmachung des Hinweises auf die Patenterteilung: **15.10.2008**
(21) Anmeldenummer: 05009532.2
(22) Anmeldetag: 30.04.2005
(51) Int. Cl.: G01R 11/04, H02B 1/03

(54) **In einen Zählschrank einbaubare Zählerplatzbaugruppe**
Subassembly of a mounting for meters mountable in a cabinet
Ensemble de montage d'une platforme de compteurs installable dans une armoire

(30) Priorität: 08.05.2004 DE 102004022784
(43) Veröffentlichungstag der Anmeldung: 09.11.2005
(73) Patentinhaber: ABB AG, 68309 Mannheim (DE)
(72) Erfinder: Roth, Michael, 77886 Lauf (DE); Armbruster, Manfred, 77855 Achern (DE)
(74) Vertreter: Partner, Lothar

(56) Entgegenhaltungen:
- DE-A1- 10 052 998
- DE-A1- 19 542 066
- DE-B3- 10 226 634
- DE-U1- 8 701 000
- DE-U1- 20 206 995
- DE-U1- 29 703 982

## Beschreibung

Die Erfindung betrifft eine in einen Zählerschrank einbaubare Zählerplatzbaugruppe nach dem Oberbegriff des Anspruches 1.

Bekannte derartige Zählerplatzbaugruppen können neben Feldern für einen Zähler und eine Verteileinrichtung noch weitere Installationsfelder enthalten, z. B. für Tag/Nachtstromsteuereinrichtungen etc. Insbesondere die Verteileinrichtung muss zur Verhinderung einer unbefugten Stromabnahme vor dem Zähler mit einer verschließbaren und plobmierbaren Abdeckung versehen sein. Anschlußräume für die Geräte der Zählersteuerung wurden bisher aufwendig abgeschottet und darüber hinaus mussten bei fehlenden Räumen Zusatzgeräte, z.B. Tarifschaltgeräte auf Klemmenabdeckungen aufgeschraubt werden.

Aus der DE 297 03 982 U1 ist eine Zählerplatzbaugruppe bekannt geworden, bei der ein Montagefeld für Verteiler, ein Feld für Zähler und ein Feld für Steuereinrichtungen an zwei parallel zueinander verlaufenden Schienen fixiert sind, wobei zwei Abdeckungen vorgesehen sind, mit denen das Montagefeld für Verteiler und das Feld für Zähler sowie das Feld für Steuereinrichtungen abgedeckt werden können.

Aus der DE 100 52 998 A1 ist eine Zählerplatzbaugruppe der eingangs genannten Art bekannt geworden, die ein Gehäuseelement für einen Zählerplatz sowie für einen Aufnahmeraum für Steuer-, Zählerzusatz- und Tarifelemente aufweist. Das Gehäuseelement ist nach vorne hin offen und auf Tragschienen aufgesetzt, wobei oberhalb des Gehäuseelementes ein Raum vorgesehen ist, der Anschlußleisten enthält, von welchen Leitungen in das Gehäuseelement hineingeführt werden können. Der Aufnahmeraum und der die Anschlußleisten enthaltende Raum sind jeweils von einem Deckel abgedeckt, die an ihren vier Ecken mit plombierbaren Verschlußbolzen fixiert sind.

Aufgabe der Erfindung ist es, eine Zählerplatzbaugruppe der eingangs genannten Art und insbesondere die Maßnahmen für eine Zugangssicherung weiter zu vereinfachen.

Diese Aufgabe wird erfindungsgemäß gelöst durch die Merkmale des Anspruches 1.

Die Erfindung ist also dadurch gekennzeichnet, dass das Trägergehäuse ein erstes Gehäuseelement aufweist, das sowohl einen den Zählerplatz bildenden Zählerplatzgehäuseabschnitt als auch den ersten Gehäuseabschnitt, die beide miteinander eine Einheit bildend verbunden sind, umfasst, wobei der Abstand der Frontfläche des Zählerplatzgehäuseabschnittes von der durch die Tragschienen aufgespannten Ebene kleiner ist als der Abstand der Frontfläche des ersten Gehäuseabschnittes von der von den Tragschienen aufgespannten Ebene, dass der Zählerabgangsabschnitt durch ein oberhalb des ersten Gehäuseelementes an den Tragschienen befestigtes zweites Gehäuseelement gebildet ist, in dem sich der Zählerabgangsraum befindet, wobei der Abstand der Frontfläche des zweiten Gehäuseelementes von der durch die Tragschienen aufgespannten Ebene größer ist als der Abstand der Frontfläche des ersten Gehäuseabschnittes von besagter Ebene, und dass der Zählerabgangsraum von dem ersten Gehäuseabschnitt mittels eines in Nuten in den Seitenwänden des ersten Gehäuseabschnittes geführten Schiebers getrennt ist, der in seiner Endstellung verrastet ist, wobei die Verrastung nur bei geöffnetem erstem Gehäuseabschnitt ermöglicht ist.

Aufgrund der unterschiedlichen Höhen der einzelnen Abschnitte wird eine deutliche Abgrenzung der einzelnen Bereiche voneinander erreicht, so dass die optische Unterscheidung der einzelnen Bereiche verbessert wird. Dies hat den Vorteil, dass die eingebaute Zählerplatzbaugruppe einen übersichtlicheren Aufbau aufweist. Dabei ist nicht nur der Bereich des Zählerplatzes vom ersten Gehäuseabschnitt, sondern auch dieser erste Gehäuseabschnitt vom Zählerabgangsbereich auch optisch getrennt.

Dadurch dass der Schieber im ersten Gehäuseabschnitt verrastet ist, kann dieser nur entrastet und herausgezogen werden, wenn der erste Gehäuseabschnitt geöffnet ist

In besonders vorteilhafter Weise ist zum Verschließen des Aufnahmeraumes des ersten Gehäuseabschnittes eine Abdeckung vorgesehen, die am Schiebergelenkig verrastet und im Bereich der Stufung plombierbar ist.

Abdeckungen, die an Trennwänden gelenkig angebracht sind, sind aus der DE 102 26 634 B3 bekannt geworden. Die Anlenkung dieser Abdeckungen hat aber lediglich den Zweck, die Abdeckungen in eine Ruhestellung zu bringen, um den Transport zu vereinfachen. Über eine Plombierbarkeit ist in dieser Druckschrift nichts ausgesagt.

In einer weiteren vorteilhaften Ausgestaltung ist die Anlenkstelle am Schieber von der Abdeckung für den Zählerabgangsraum abgedeckt, so dass die Abdeckung für den ersten Gehäuseabschnitt nur dann entfernbar ist, wenn die Abdeckung für den Zählerabgangsraum entfernt ist.

Dies hat den Vorteil, dass ein Zugang zu den Zusatz,- Steuer- und Tarifgeräten, welcher Raum als E1/U-Raum bezeichnet ist, erschwert ist.

Dabei ist die Abdeckung für den Zählerabgangsraum im Bereich des Schiebers plombierbar, wobei am Schieber geeignete Maßnahmen getroffen sind.

In besonders vorteilhafter Weise kann das erste Gehäuseelement einstückig sein. Es besteht auch die Möglichkeit, da der Zählerplatzgehäuseabschnitt und der erste Gehäuseabschnitt miteinander durch Verrastung, Verklebung oder Verschweißung miteinander verbunden sind.

Dadurch bildet das erste Gehäuseelement eine Einheit, die vormontiert werden kann. Diese Einheit ist von den anderen angrenzenden Bereichen allseitig abgetrennt.

Damit elektrische Leiter durch den Schieber hindurchgeführt werden können, besitzt der Schieber ausbrechbare Wandabschnitte.

Anhand der Zeichnungen, in denen ein Ausführungsbeispiel der Erfindung dargestellt ist, sollen die Erfindung, weitere Ausgestaltungen und Verbesserungen sowie weitere Vorteile näher erläutert und beschrieben werden.

Es zeigen:
- Fig. 1: eine Zählerplatzbaugruppe in liegender Darstellung, in perspektivischer Ansicht und in einem ersten Montagezustand,
- Fig. 2: die Zählerplatzbaugruppe gemäß Fig. 1 in einem weiteren Montagezustand,
- Fig. 3: die Zählerplatzbaugruppe gemäß den Figuren 1 und 2 in einem dritten Montagezustand,
- Fig. 4: eine Einsicht in den EVU-Abschnitt im Montageschritt gemäß Fig. 1 und
- Fig. 5: einen Montagezwischenschritt zur Darstellung der Anbringung der Abdeckung für den EVU-Abschnitt.

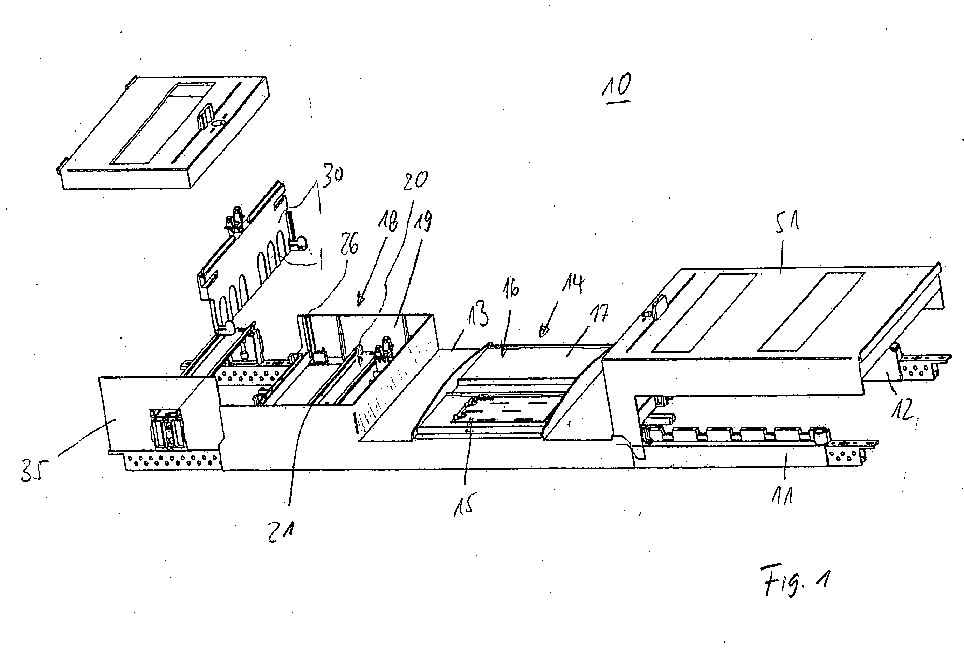

Die Fig. 1 zeigt eine perspektivische Ansicht einer Zählerplatzbaugruppe 10, in liegender Darstellung. Im montierten Zustand würde die Zählerplatzbaugruppe senkrecht im Schaltschrank untergebracht sein.

Die Zählerplatzbaugruppe 10, kurz auch Baugruppe 10 genannt, umfasst zwei Tragschienen 11 und 12, auf denen die einzelnen Komponenten der Baugruppe 10 untergebracht sind. Annähernd im mittleren Bereich befindet sich ein erstes Gehäuseelement 13, an dem ein Zählerplatzabschnitt 14 zur Aufnahme eines Zählers untergebracht ist. Dabei sind zwei Zählerplätze 15 und 16 vorgesehen, von denen der Zählerplatz 15 eingerichtet ist, um einen Zähler aufzunehmen; die Ausgestaltung eines solchen Zählerplatzes ist insbesondere der DE 10 2004 022 785.3 (Mp.-Nr. 04/555) zu entnehmen. Der andere Zählerplatz 16 ist mittels einer Abdeckplatte 17 abgedeckt. An den Zählerplatzabschnitt 14 schließt sich ein Abschnitt 18 an, der ein Gehäuseelementabschnitt 19 aufweist, in dem Zählerzusatz-, Tarif- und Steuergeräte untergebracht sind und der im folgenden auch EVU-Aufnahmeraum, kurz EVU-Raum genannt wird und hierbei die Bezugsziffer 20 erhält. Am Boden dieses EVU-Aufnahmeraumes 20 befindet sich eine Hutprofiltragschiene 21, auf der die Geräte aufgesetzt werden können.

Der Abstand A₁₈ der Frontseite bzw. Frontfläche 22 des Abschnittes 18 von der durch die Tragschienen 11 oder 12 aufgespannten Ebene ist größer als der Abstand A₁₄ der Frontfläche des Zählerplatzabschnittes 14 von besagter Ebene, so dass hierdurch eine Stufung 23 gebildet ist, über die die beiden Abschnitte 14 und 18 voneinander getrennt sind.

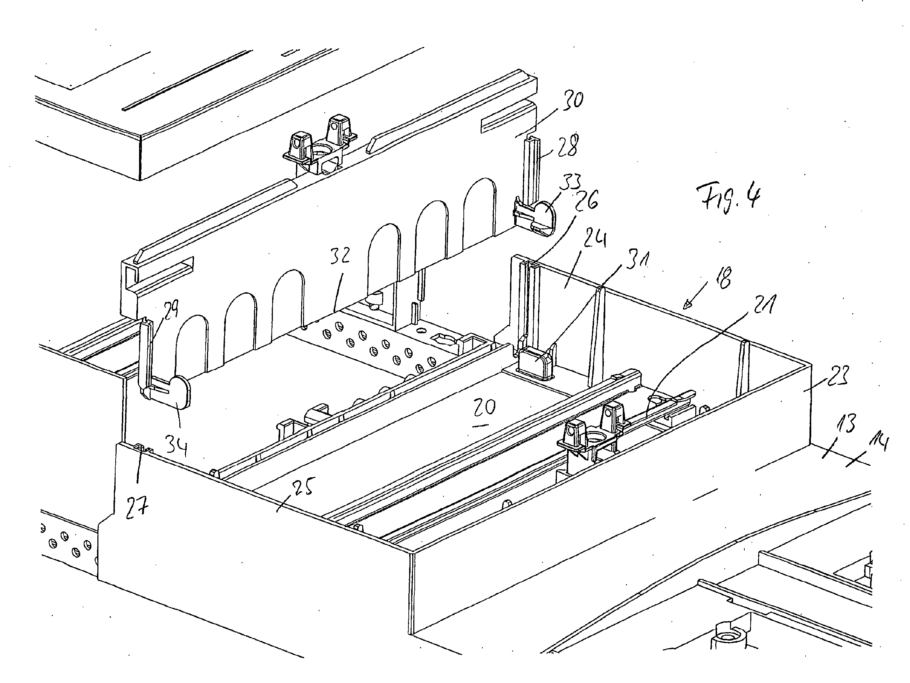

Es sei nun Bezug genommen auf die Fig. 4.

An der Innenfläche des Gehäuseelementabschnittes 18 in dem in der Fig. 4 links befindlichen Endbereich befinden sich an den Innenwandungen der Seitenwände 24 und 25 T-förmige Nuten 26, 27, in die entsprechend ausgebildete T-förmige Leisten 28 und 29 eines Schiebers 30 einfügbar sind, so dass der EVU-Raum 20 an der der Stufung 23 entgegengesetzt liegenden Seite des Gehäuseabschnittes 18 abgeschlossen ist.

Am Boden des Gehäuseelementabschnittes 18 befinden sich im Bereich der Seitenwand 24 Pfosten 31; der Pfosten im Bereich der Seitenwand 25 ist nicht zu sehen. Am Schieber 30 an dessen zum Gehäuseboden hin gewandten Kante 32 befinden sich senkrecht zum Schieber 30 vorspringende Rastvorsprünge 33 und 34, die hinter nicht sichtbaren Raststellen der Pfosten 31 einrasten können, so dass der Schieber 30 mit dem Gehäuseabschnitt 18 verrastet ist. Die Fig. 4 zeigt den Bereich des Abschnittes 18 in vergrößerter Darstellung, wobei der Schieber 30 noch nicht in den Nuten 26, 27 eingeschoben ist. Diese Raststellen können nur bei offenen EVU-Raum entrastet werden.

Im montierten Zustand oberhalb des Gehäuseelementabschnittes 18 und in der Fig. 1 links desselben befindet sich ein zweites Gehäuseelement 35, welches ebenfalls auf den Trägerschienen 11, 12 befestigt ist, wobei der Abstand A₃₅ der Frontfläche 36 von der Ebene, die durch die Trägerschienen 11, 12 aufgespannt wird, größer ist als der Abstand A₁₈, wodurch auch hier eine Stufung 37 gebildet ist, die zur besseren optischen Unterscheidung des Gehäuseelementabschnittes 18 vom Gehäuseelement 35 dient.

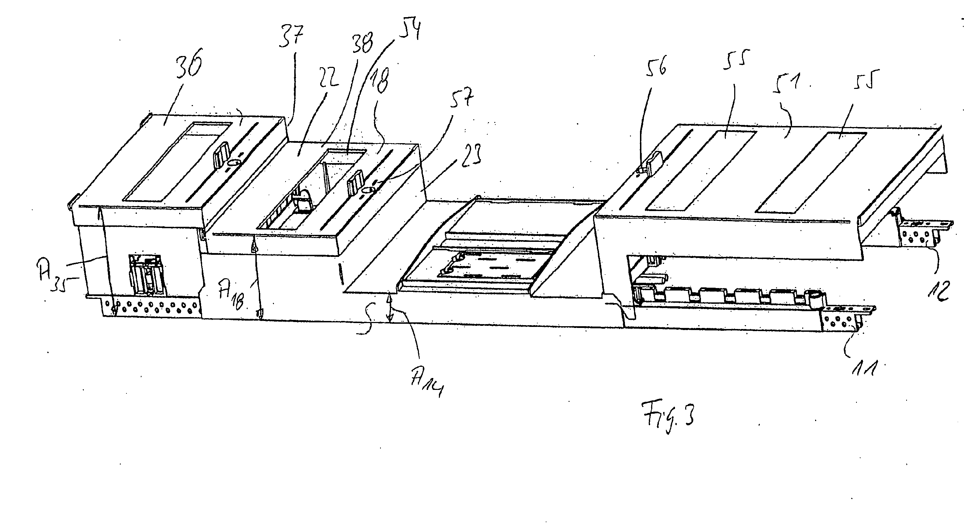

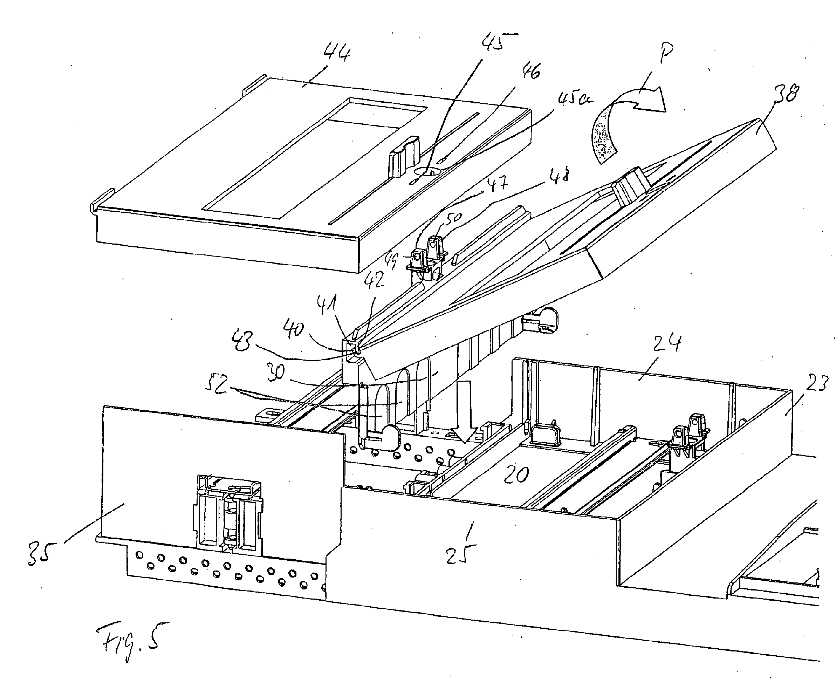

Die Montage erfolgt so, wie in Fig. 5 dargestellt:
Der Abschnitt 18 ist von einer Gehäuseabdeckung 38 abgedeckt, die an ihrer dem Schieber 30 zugewandten, quer zu den Trägerschienen 11, 12 verlaufenden Kante einen Haken 40 aufweist, der in eine U-förmige Vertiefung 41 eingesetzt wird. Diese U-förmige Vertiefung 41 wird durch eine L-förmige Anformung 42 am Schieber 30 gebildet, dessen freier Schenkel 43 nach unten, d.h. zur unteren Kante 32 zurückgebogen ist. Man könnte auch sagen, dass der freie Schenkel 43 hinter den Haken 40 greift. Dadurch kann die Abdeckung 38 nach Einhaken hinter den freien Schenkel 43 in Pfeilrichtung P verschwenkt werden, so dass nach Einschieben des Schiebers 30 in die entsprechenden Nuten der Deckel 38 auf der Stufung 23 sowie auf den Seitenwänden 24 und 25 aufliegt. Die Abdeckung ist, ebenso wie die Anordnung der Seitenwände 24, 25 mit der Stufung 23 und dem eingesetzten Schieber, napfförmig; in entsprechender Weise ist auch die Abdeckung 38 napfförmig, so dass sie als Deckel den EVU-Raum 20 abschließt, wie in der Fig. 3 zu sehen.

Nach Auflegen der Abdeckung 38 wird über das zweite Gehäuseelement 35 eine dazu gehörige zweite Abdeckung 44 gesetzt, die dann mittels einer nicht näher dargestellten Schraubenverbindung in einer Plombierungsöffnung 45a an dem Schieber 30 befestigt ist; die Abdeckung 44 besitzt Plombierungsöffnungen 45, 46 und am Schieber 30 sind Plombierungspfosten 47, 48 angebracht, die Plombierungsöffnungen 49, 50 aufweisen; nun kann ein Plombierdraht durch die Öffnungen 45, 46, 49, 50 und auch durch die - nicht gezeigte Schraube - hindurchgefädelt werden, wodurch die Abdeckung 44 auch gesichert ist.

In entsprechender Weise besitzt auch der EVU-Abschnitt 18 eine Plombierung, die der eben beschriebenen Plombierung entspricht und hier nicht näher erläutert werden soll.

Auf der dem zweiten Gehäuseelement entgegengesetzten Ende der beiden Trägerschienen 11, 12 ist ein drittes Gehäuseelement 51 vorgesehen, das auf den Trägerschienen 11, 12 in nicht näher beschriebener Weise befestigt ist und das Sicherungselemente, Hauptleitungsschutzschalter und dergleichen abdeckt.

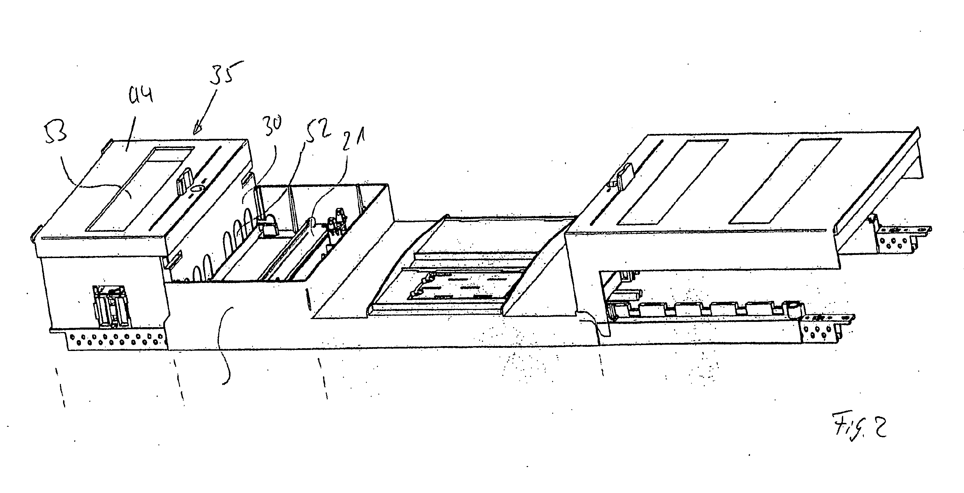

Die Fig. 2 zeigt die Ausführungsform gemäß den Figuren 1 und 3, mit noch offenem EVU-Raum 20.

Der Schieber 30 besitzt mehrere ausbrechbare Wandungen 52, durch die Abgangsleiter in den Zählerabgangsraum hineingeführt werden. Die Abdeckung 44 besitzt dabei eine Durchtrittsöffnung 53 für darin befindliche Geräte.

In gleicher Weise besitzt auch die Abdeckung 38 eine Durchtrittsöffnung 54 zum Zugang zu innerhalb des EVU-Raumes 20 befindlichen Geräten.

Das dritte Gehäuseelement 51, das Sicherungselemente und dergleichen abdeckt, besitzt hier zwei Aussparungen wie diejenigen gemäß den Bezugsziffern 53 und 54, die beide mit der Bezugsziffer 55 bezeichnet sind.

Auch das dritte Gehäuseelement 51 kann über eine Plombierungseinrichtung 56 plombiert werden, die der Plombierungseinrichtung für die Abdeckung 44 entspricht. Die Plombierung für die Abdeckung 38 ist mit 57 bezeichnet.

Zur Montage in den Zählerschrank wird die Ausführung, wie sie in Fig. 3 dargestellt ist, senkrecht gestellt und die Trägerschienen 11, 12 innerhalb des Zählerschrankes fixiert und befestigt.

Die Trägerschienen können vorzugsweise aus Stahlblech hergestellt sein.

## Patentansprüche

1. In einen Zählerschrank einbaubare Zählerplatzbaugruppe (10) mit einem auf vertikal verlaufenden Tragschienen befestigten Trägergehäuse, das einen Zählerplatz, an dem wenigstens ein elektrischer Stromzähler befestigbar ist, einen vertikal darüber anschließenden ersten Gehäuseabschnitt (19) zur Aufnahme von Zählerzusatz-, Tarif- und Steuergeräten, einen vertikal oberhalb des ersten Gehäuseabschnittes (19) befindlichen Zählerabgangsgehäuseabschnitt (35) und einen unterhalb des Zählerplatzes (14) befindlichen unteren zweiten Gehäuseabschnitt zur Aufnahme von Sicherungen und Hauptleitungsschutzschaltern umfasst, wobei das Trägergehäuse ein erstes Gehäuseelement (13) aufweist, das sowohl einen den Zählerplatz bildenden Zählerplatzgehäuseabschnitt (14) als auch den ersten Gehäuseabschnitt (19), die beide miteinander eine Einheit bildend verbunden sind, umfasst, wobei der Abstand (A14) der Frontfläche des Zählerplatzgehäuseabschnittes (14) von der durch die Tragschienen aufgespannten Ebene kleiner ist als der Abstand (A18) der Frontfläche (22) des ersten Gehäuseabschnittes (19) zu der von den Tragschienen aufgespannten Ebene, wobei der Zählerabgangsgehäuseabschnitt (36) durch ein oberhalb des ersten Gehäuseelementes (13) an den Tragschienen befestigtes zweites Gehäuseelement (35) gebildet ist, in dem sich der Zählerabgangsraum befindet, **dadurch gekennzeichnet, dass** der Abstand (A35) der Frontfläche des zweiten Gehäuseelementes (35) von der durch die Tragschienen aufgespannten Ebene größer ist als der Abstand (A18) der Frontfläche des ersten Gehäuseabschnittes (19) von besagter Ebene, und dass der Zählerabgangsraum von dem ersten Gehäuseabschnitt (19) mittels eines in Nuten (26,27) in den Seitenwänden des ersten Gehäuseabschnittes (19) geführten Schiebers (30) getrennt ist, der in seiner Endstellung verrastet ist, wobei die Verrastung nur bei geöffnetem erstem Gehäuseabschnitt (19) ermöglicht ist.

2. Zählerplatzbaugruppe nach Anspruch 1, **dadurch gekennzeichnet, dass** zum Verschließen des Aufnahmeraumes (20) des ersten Gehäuseabschnittes (19) eine Abdeckung (22) vorgesehen ist, die am Schieber (30) gelenkig angeschlossen und die im Bereich der Stufung (23) plombierbar ist.

3. Zählerplatzbaugruppe nach einem der Ansprüche 1 oder 2, **dadurch gekennzeichnet, dass** die Anlenkstelle der Abdeckung (22) am Schieber (30) von der Abdeckung (36) für den Zählerabgangsabschnitt abgedeckt ist, so dass die Abdeckung für den ersten Gehäusabschnitt (19) nur dann entfernbar ist, wenn die Abdeckung (36) für den Zählerabgangsraum entfernt ist.

4. Zählerplatzbaugruppe nach Anspruch 3, **dadurch gekennzeichnet, daß** die Abdeckung (36) am Schieber (30) plombierbar ist.

5. Zählerplatzbaugruppe nach einem der vorigen Ansprüche, **dadurch gekennzeichnet, dass** das erste Gehäuseelement (13) einstückig ist.

6. Zählerplatzbaugruppe nach einem der Ansprüche 1 bis 3, **dadurch gekennzeichnet, dass** der Zählerplatzgehäuseabschnitt (14) und der erste Gehäuseabschnitt (19) durch Verrastung, Verklebung oder Verschweißung miteinander verbunden sind.

7. Zählerplatzbaugruppe nach einem der vorigen Ansprüche, **dadurch gekennzeichnet, dass** der Schieber (30) ausbrechbare Wandabschnitte (52) zur Durchführung elektrischer Leiter aufweist.

## Claims

1. A meter position module (10) to be installed in a meter cabinet, comprising a support housing which is fastened to vertically extending support rails and which comprises a meter position to which at least one electric meter can be fastened, a first housing section (19) adjacent vertically above for receiving auxiliary meter devices, tariff and control devices, an upper meter output section (35) situated vertically above the first housing section (19) and a lower second housing section situated beneath the meter position for receiving fuses and line circuit breakers, with the support housing comprising a first housing element (13) which comprises both a meter position housing section (14) forming the meter position and the first housing section (19) which both connected to jointly form a unit with each other, with the distance (A14) of the front surface of the meter position housing section (14) from the plane formed by the support rails is smaller than the distance (A18) of the front surface (22) of the first housing section (19) relative to the plane formed by the support rails, with the meter output housing section (36) being formed by a second housing element (35) fastened to the support-rails above the first housing element (13) in which the meter output chamber is located, **characterized in that** the distance (A35) of the front surface of the second housing element (35) from the plane formed by the support rails is larger than the distance (A18) of the front surface of the first housing section (19) of said plane, and that the meter output chamber is separated from the first housing section (19) by means of a slide (30) guided in the grooves (26, 27) in the side walls of the first housing section (19), which slide is latched in its end position, with the latching only being enabled when the first housing section (19) is opened.

2. A meter position module according to claim 1, **characterized in that** a cover (22) is provided for closing the receiving chamber (20) of the first housing section (19), which cover is linked to the slide (30) and can be sealed in the area of the stepping (23).

3. A meter position module according to one of the claims 1 or 2, **characterized in that** the linkage point of the cover (22) on the slide (30) is covered by the cover (36) for the housing output section, so that the cover for the first housing section (19) can only be removed when the cover (36) for the housing output chamber is removed.

4. A meter position module according to claim 3, **characterized in that** the cover (36) on the slide (30) can be sealed.

5. A meter position module according to one of the preceding claims, **characterized in that** the first housing element (13) is integral.

6. A meter position module according to one of the claims 1 to 3, **characterized in that** the meter position housing section (14) and the first housing section (19) are connected with each other by latching, gluing or welding.

7. A meter position module according to one of the preceding claims, **characterized in that** the slide (30) comprises wall sections (52) which can broken off for leading through electrical leads.

## Revendications

1. Module (10) d'emplacement de compteur pouvant être installé dans une armoire de compteur, comprenant un boîtier porteur fixé sur un rail porteur à trajet vertical, qui comporte un emplacement de compteur, au niveau duquel au moins un compteur de courant électrique peut être fixé, une première section de boîtier (19) se raccordant verticalement dessus pour la réception d'appareils de contrôle, de comptage supplémentaire et de tarification, une section de boîtier de départ de compteur (35) se trouvant verticalement au-dessus de la première section de boîtier (19) et une seconde section de boîtier, inférieure, se trouvant en dessous de l'emplacement de compteur (14), pour la réception de fusibles et de disjoncteurs principaux, le boîtier porteur présentant un premier élément de boîtier (13) qui comporte une section de boîtier (14) d'emplacement de compteur formant l'emplacement de compteur, mais aussi la première section de boîtier (19), qui sont reliées toutes les deux ensemble pour former un bloc, la distance (A14) de la surface frontale de la section de boîtier (14) de place de compteur par rapport au plan enserré par les rails porteurs est inférieure à la distance (A18) de la surface frontale (22) de la première section de boîtier (19) par rapport au plan enserré par les rails porteurs, la section de boîtier de départ de compteur (36) étant formée d'un second élément de boîtier (35) fixé au-dessus du premier élément de boîtier (13) au niveau des rails porteurs, dans lequel se trouve le compartiment de départ de compteur, **caractérisé en ce que** la distance (A35) de la surface frontale du second élément de boîtier (35) par rapport au plan enserré par les rails porteurs est supérieure à la distance (A18) de la surface frontale de la première section de boîtier (19) par rapport audit plan, et le compartiment de départ de compteur est séparé de la première section de boîtier (19) par un coulisseau (30), guidé dans des rainures (26, 27) des parois latérales de la première section de boîtier (19), et est encliqueté dans sa position finale, l'encliquetage n'étant permis que lorsque la première section de boîtier (19) est ouverte.

2. Module d'emplacement de compteur selon la revendication 1, **caractérisé en ce qu'**un couvercle (22) est prévu pour fermer le compartiment de réception (20) de la première section de boîtier (19), qui est raccordé de manière articulée au coulisseau (30) et peut être plombé dans le secteur de l'étagement (23).

3. Module d'emplacement de compteur selon la revendication 1 ou 2, **caractérisé en ce que** le point d'articulation du couvercle (22) est couvert au niveau du coulisseau (30) par le couvercle (36) de la section de .départ de compteur, de sorte que le couvercle de la première section de boîtier (19) ne peut donc être retiré que lorsque le couvercle (36) du compartiment de départ de compteur est retiré.

4. Module d'emplacement de compteur selon la revendication 3, **caractérisé en ce que** le couvercle (36) peut être plombé au niveau du coulisseau (30).

5. Module d'emplacement de compteur selon l'une quelconque des revendications précédentes, **caractérisé en ce que** le premier élément de boîtier (13) est d'un seul tenant.

6. Module d'emplacement de compteur selon l'une quelconque des revendications 1 à 3, **caractérisé en ce que** la section de boîtier d'emplacement de compteur (14) et la première section de boîtier (19) sont reliées ensemble par un encliquetage, un collage ou un soudage.

7. Module d'emplacement de compteur selon l'une quelconque des revendications précédentes, **caractérisé en ce que** le coulisseau (30) présente des sections de paroi (52) pouvant être rompues pour une mise en oeuvre de conducteurs électriques.
